Europäisches Patentamt

(19) European Patent Office

Office européen des brevets

(11) Publication number: **0 151 873**
**B1**

(12) **EUROPEAN PATENT SPECIFICATION**

(45) Date of publication of patent specification: **08.11.89**

(21) Application number: **84308430.2**

(22) Date of filing: **05.12.84**

(51) Int. Cl.⁴: **B 29 C 33/68**

(54) **Mold release sheet and method of manufacture.**

(30) Priority: **09.12.83 US 559801**
**01.10.84 US 656207**

(43) Date of publication of application:
**21.08.85 Bulletin 85/34**

(45) Publication of the grant of the patent:
**08.11.89 Bulletin 89/45**

(84) Designated Contracting States:
**DE FR GB IT**

(56) References cited:
**DE-A-1 911 894**
**DE-A-2 816 090**
**US-A-2 652 597**
**US-A-3 667 994**
**US-A-4 311 766**
**US-A-4 362 585**
**INTERNATIONAL POLYMER SCIENCE AND**
**TECHNOLOGY, vol. 5, no. 9, September 1978,**
**page T71,T72, Shrewsbury, GB; E.G. BABLYUK**
**et al.: "Influence of corona discharge on the**
**properties of the surface of PETP film"**
**ADHÄSION, vol. 23, no. 5, May 1979, pages**
**136-142, Munich, DE; J. HANSMANN: "Corona-**
**Oberflächenbehandlung"**

(73) Proprietor: **Wilheim, Martin J.**
**52 Elm Avenue**
**Larchmont New York (US)**

(72) Inventor: **Wilheim, Martin J.**
**52 Elm Avenue**
**Larchmont New York (US)**
Inventor: **Tripp, Edwin P.**
**6 Woodland Drive**
**Wilmington Massachusetts 01887 (US)**

(74) Representative: **Allsop, John Rowland**
**Rowland Allsop & Co. Black Boy Yard 15 High**
**Street**
**West Wycombe High Wycombe, Bucks. HP14**
**3AE (GB)**

## Description

### Background of the invention

Numerous mold release sheets have been proposed for facilitating the release of the molded laminated structures from the molds in which they are formed. Such release sheets have included single layer sheets, multilayer sheets and coated sheets. For example, a polypropylene layer on kraft paper or cellophane has been suggested for making floor and wall coverings (U.S. Pat. No. 3,507,733); and aluminum foil kraft paper composites have been disclosed for making embossed laminates (U.S. 3,700,537).

Thermoplastic materials such as Surlyn ionomer resin; Tedlar polyvinyl fluoride material and Mylar polyester material, all Du Pont products, have been used or suggested for possible use as release sheets under specific molding conditions (U.S. Pat. No. 3,969,174).

Release sheets with cured coating have also been disclosed (U.S. Pat. No. 4,166,150) and various methods of preparing release sheets published (U.S. Pat. No. 4,243,461; and U.S. Pat. No. 4,263,073).

Mold release sheets have also been proposed for the processing and production of epoxy laminates and multilayered circuit board laminates. For example, the above-mentioned Tedlar product has been used as a release sheet for epoxy multilayered circuit boards.

According to the invention there is provided a mold release sheet structure in medium to high pressure laminate molding at high temperature wherein said release sheet is intermediate to and in contact with laminate-making layer such as pressed-together press plates, caul plates, kraft sheets, and coverlay sheets, the release sheet structure comprising a surface treated polyester, nylon or cellulose acetate film having two sides, such treatment of the film promoting resin adhesion; and a first thin release layer of a cured acrylated oligomer release resin on at least one side of the film, said release resin being readily releasable from said laminate-making layers.

It is a feature of this invention that the polyester, nylon or cellulose acetate films used as a substrate are thermally stable, coatable, have high service temperature, good dimensional stability, high tensile strength and smooth level surfaces. In addition, such films have good lay-flat characteristics and are readily available at reasonable prices.

It is a further feature of the invention that the release coatings can be applied to the film in textured patterns which patterns in turn serve to produce a mirror pattern on the unclad surfaces of laminate components. Textured patterned surfaces assist in bonding between laminate components in multilayer fabrications.

### Brief description of the drawings

Fig. 1 is a schematic elevational view showing the manufacturing process of the mold release sheet structure including the corona and electron beam stations;

Fig. 2 is an elevational view of the corona treatment station;

Fig. 2a is an elevational view of a second corona treatment station;

Fig. 3 is a sectional view of the electron beam station along line 3—3 of Fig. 1; and

Fig. 4, is an exploded elevational view of a laminating mold using release sheets of the present invention.

### Description of the preferred embodiment

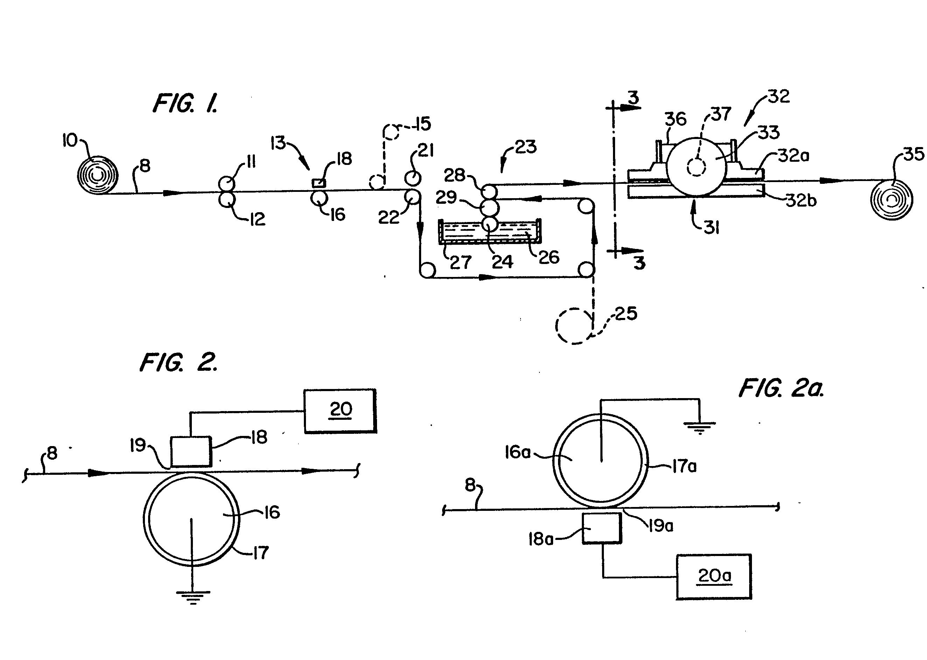

Turning to Fig. 1, a polyester film 8 (such as ICI America's Melinex 442, Melinex S, or equivalent) having a thickness in the range of 0,127 mm to 0,0127 mm (.005 inches to .0005 inches) and preferably about 0,02337 mm (.00092 inches) (and having any selected width which is suitable for handling by the process equipment used) is fed from feed roll 10 through drive rolls 11, 12 to corona treatment station 13. Melinex is a polyester material formed of polyethylene terephthalate. Polyester films are hydrophobic. Alternatively, nylon films having the coating receptivity and heat resistance as required may also be used. In particular any film made of Type 66 polymer has been found useful. Type 66 polymers comprise polymers which are the condensation product of adipic acid and hexamethylene diamine. The film also includes an addition agent to provide for high heat resistance. The polymer has a specific gravity of about 1.13. Such nylon films (which are preferably of the thickness of about 1 to about 4 have a melting temperature of about 265°C (510°F). In addition, film 8 may be a cellulose acetate film, and particularly a triacetate cellulose film HP-550 AA produced by Courtaulds C.P.D. Inc.

Corona treatment station 13 (such as Deerpark Industries DP-9018 Treat Station with an ENI Model RS-96 Power Supply) includes roller electrode 16 (See Fig. 2) covered with dielectric insulating cover 17 and linear electrode 18. The air gap 19 between linear electrode 18 and cover 17 is about 1,016—2,032 mm (.040—.080 inches). A high frequency and high voltage power source 20 causes corona discharges to pass from the linear electrode 18 to the roller electrode 16 as film 8 passes through air gap 19 thus treating the film surface to a dyne level in the order of 72 which treatment makes the film surface more receptive to the release coating to be later applied. Treated film 8 may be diverted to take up intermediate roll 15 or fed to the subsequent stations as further described. Alternatively, the film may be treated by other means such as chemical, mechanical or other treatment means to promote satisfactory adhesion.

The purpose of the corona or other film surface treatment is to promote adhesion of the coating to the film and to improve the wetability of the surface.

Referring again to Fig. 1, second feed roller pair 21, 22 carry film 8 next to coating station 23 where engraved gravure roll 24 picks up a coating such as Mobil Chemical No. 82XE087 or Inmont Corporation Chemical No. NBE 1102, both curable acrylated resins, from coating bath 26 in reservoir tank 27. The Mobil product is an acrylated oligomer or resin which may include an acrylated epoxy or acrylated urethane. These coating resins may be diluted with acrylate monomers to reduce viscosity or other monomers such as N-vinyl pyrrolidone. The coating may also include flatting agents, release additives, clays, and pigments. Gravure cylinder roller 24 then transfers the coating to rubber transfer roller 29 which in turn transfers the coating to the topside of film 8. Gravure cylinder 24 has numerous etched cells in its surface which deposit a uniform and predetermined amount of coating. This amount of coating can be changed by using different gravure cylinders and will affect the surface topography of the coated substrate. Back-up roll 28 is also shown. Gravure rollers having differing numbers of cells per area may be used to obtain the desired pattern. Besides offset gravure, other coating techniques for coating film 8 may also be used, including the direct gravure method; the Meyer rod method, or use of multiple smooth rolls where the amount of coating is determined by setting a gap between two coating rolls. Preferably the application provides a thin coating requiring only about 1.5 to about only 6 (preferably 3 to 4) pounds of coating per 279 m² (three thousand (3000) square feet) of film surface.

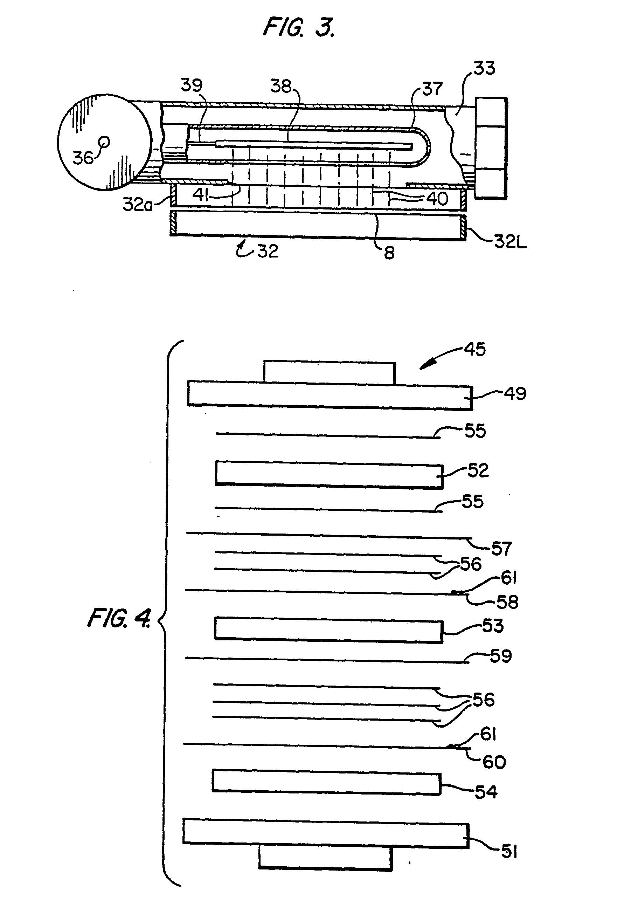

Next, coated film 8 enters electron beam curing station 31 where the coating is cured. Station 31 includes film passage assembly 32, with upper and lower sections 32a, 32b, electron accelerator housing 33, and power supply 36. Turning to Fig. 3, it is seen that electron accelerator housing 33 carries in it a tubular beam control assembly 37 which in turn contains a linear electron beam element 38 mounted on extension arm 39. Electron beam element 38 discharges downwardly a curtain (strip) of electrons (depicted by a plurality of lines 40) through window 41 in upper section 32a. Alternatively, a point (or "pencil") type cathode scanner equipment may be used which projects a beam of electrons which can be scanned or swept over the coated film. The bombardment of the coated film by electrons initiates a polymerization reaction in the coating and forms a dry, tack-free product. Curing doses typically in the range of 1.5 to 3.0 megarads have been found satisfactory for curing the coatings as applied to the moving film 8. As cured, the film surface coating has a distinct textured pattern which pattern can serve to form or impress a reverse pattern in the surface of an adjacent laminate of a molded product.

The film, as cured, is wound on take up roll 35. Preferably, film 8 is then processed a second time to treat and coat the opposite side; however, since a second pass through the corona station can result in degrading the release properties of the first-pass coating, the following procedure can be followed.

1. First, the film is passed through the corona station to only treat side one of the film;

2. The film is turned over and passed through the corona station to treat the second side and in a continuous manner is coated and cured to provide a cured coat on the second side;

3. The film is again turned over, mounted on feed roll 25 (Fig. 1), and passed through coating and curing stations (but not corona treatment) to provide a cured coating on the first side.

By following this procedure, the film passes through the corona only once with a coating on it to avoid double corona treatment of a coating layer.

Alternatively, corona treatment can be accomplished by employing an additional corona station 13a (Fig. 2a) to accomplish treating both sides of sheet 8 in one pass. Station 13a, when used, is preferably inserted in the process shown in Fig. 1 immediately before or immediately following corona station 13. Station 13a is identical to station 13 except it is inverted to treat the bottom side of film 8.

The present invention is directed to the production of the laminate components and also to the fabrication of multilayer laminate products. Laminate components are used to construct multilayer laminates comprising one or more laminate components. Laminate components may include one side clad, two sides clad, or no side clad. Prepreg sheets are used both in manufacture of laminate components and to affix one laminate component to another in multilayer fabrication.

Advantages of the release sheet structure for use in manufacture of laminate components (like FR-4 type laminates) used in the circuit board and other industries include the release sheet structure's (1) ability to withstand molding temperatures between 171—188°C (340°—370°F) for 30—60 mintues (or longer) at pressures of 2,7—6,9 MPa (400—1000 psi) without softening, shrinking, embrittling or discharging of gas odor; (2) substantially inert properties which prevent adverse affects on the chemical, electrical or physical properties of adjacent laminates; (3) translucency which is desirable for quality control inspection of a product pressed against it; (4) strength that enables it to be readily stripped after completion of the molding operation; (5) excellent releasing properties from adjacent surfaces including epoxy resins even when subjected to variable molding conditions including extreme heat, pressure, and time; and (6) ability to impart a matte finsih, texture, or controlled gloss to the unclad surface of laminate components.

The use of the present release sheet structure in multilayer manufacture has the following additional advantages. The release sheet structure:

i) does not stick to the clad, the prepreg sheet, the kraft sheet nor the laminate surfaces;

ii) assists in preventing migration of flowable material from one laminate component to another;

iii) does not shrink;

iv) is resistant to embrittlement;

v) has good tensile strength;

vi) has sufficient rigidity to assist in handling;

vii) does not emit excessive odors;

viii) minimizes the static electric charges, thus easing removal from the mold; and

ix) has good hole-forming characteristics whether drilled or punched.

The texture of the surface of the release sheet structure is caused by the amount of coating deposited, the rheology of the coating and the way the coating transfers to the film substrate. The release sheet structure of the present invention also improves the unclad surface of epoxy-glass laminate components by reducing the height of glass protrusions (or "knuckles") above the surface of the laminate. This action of the release sheet structure causes the rough epoxy-glass surface to exhibit a more resin-rich characteristic in that the surface functions as if it had increased the epoxy resin and lessened the glass at the surface.

Turning finally to Fig. 4, a mold 45 is shown for forming laminate components. Mold 45 includes press platens 49, 51; metal caul plates 52, 53 and 54; kraft sheets 55 for texture formation or to assist in heat transfer; other laminate-making layers 56 used in laminate component production; and finally coated release sheet structure of the present invention 57, 58, 59 and 60 selectively interleaved among the laminate-making layers 56 and the press platens and caul plates 49, 51, 52, 53 and 54. Release sheet structures 57, 58, 59 and 60 are larger in area than the laminate-making layers 56 to prevent melting resin material 61 from migrating from one laminate-making layer 56 to another laminate-making layer 56.

Example

A roll of 0,02337 mm (.00092") thick Melinex 442 film having a width of 54" was passed through corona treatment station 13 to treat one side of the film. The film was then turned over and passed through the corona station a second time to treat the other side and then passed through coating station 23 and curing station 31 to cause a textured cured coating of Mobil No. 82XE087 resin material to be formed on one side of the film.

The coated film was turned over and a similar cured coating formed on the other side.

In the manufacture of laminates including printed circuit boards (PCB's), laminated components are initially produced using molding techniques and thereafter such components together with further laminates are molded to form the final product. The mold release sheet structure of the present invention is useful in many laminate molding operations using press platens with or without caul plates.

Claims

1. A mold release sheet structure in medium to high pressure laminate molding at high temperature wherein said release sheet is intermediate to and in contact with laminate-making layers such as pressed-together press plates, caul plates, kraft sheets, and coverlay sheets, the release sheet structure comprising

a surface treated polyester, nylon or cellulose acetate film having two sides, such treatment of the film promoting resin adhesion; and

a first thin release layer of a cured acrylated oligomer release resin on at least one side of the film, said release resin being readily releasable from said laminate-making layers.

2. A mold release sheet structure as claimed in claim 1 wherein, in addition to the first thin layer a second thin layer of the same resin is provided on the other side of the film.

3. A mold release sheet structure as claimed in claim 1 in which the resin is an electron beam curable resin.

4. A mold release sheet structure as claimed in claim 1 in which the film is a polyester film comprising polyethylene terephthalate.

5. A mold release sheet structure as claimed in claim 1 in which the nylon film includes heat stabilized Type 66 nylon resin.

6. A laminate system including a release sheet structure in medium to high pressure laminate molding at high temperatures wherein said release sheet is intermediate to and in contact with laminate-making layers such as press-together press plates, caul plates, kraft sheets and coverlay sheets, such release sheet having, in combination, a sheet of thermally and dimensionally stable, smooth and high-tensile-strength coatable plastic polyester, nylon cellulose acetate, polyethersulfone, polyetherimide or polyimide substrate at least one surface of which has been treated to render the same receptive to an acrylated oligomer liquid resin coating material, a thin layer of such resin coating material applied to the treated surface and cured thereupon and thereto, said resin being readily releasable from such laminate making layers.

7. A laminate system as claimed in claim 6 wherein said resin is of the electron beam radiation curable type and is cured by such radiation.

8. A laminate system as claimed in claim 6 wherein the release sheet is of area larger than the laminates.

Patentansprüche

1. Trennfolie für Hochdruck-Laminat-Formgebung bei hohen Temperaturen, wobei die Trennfolie zwischen und in Kontakt mit laminatbildenden Schichten wie Press-Verbund-Platten, Netz-Platten, Kraft-Blättern und Deck-Blättern angeordnet ist, wobei die Trennfolie einen oberflächenbehandelten Polyester-, Nylon- oder Zelluloseazetatfilm mit zwei Seiten aufweist und wobei die Behandlung des Films der Harzhaftung dient, sowie eine erste dünne Trennschicht aus gehärtetem acryliertem Oligomer-Trenn-Harz auf wenigstens einer Seite des Films, wobei das Trenn-Harz leicht von der laminatbildenden Schicht zu trennen ist.

2. Trennfolie gemäß Anspruch 1, bei der zusätzlich zur ersten dünnen Schicht eine zweite dünne Schicht desselben Harzes auf der anderen Seite des Films vorhanden ist.

3. Trennfolie gemäß Anspruch 1, bei der das Harz im Elektronenstrahl härtbar ist.

4. Trennfolie nach Anspruch 1, bei der der Film ein Polyesterfilm mit Polyethylenterephtalat ist.

5. Trennfolie gemäß Anspruch 1, bei der der Nylonfilm hitzestabilisiertes Nylon-Harz vom Typ 66 enthält.

6. Laminat-System mit einer Trennfolie für Hochdruck-Laminat-Formgebung bei hohen Temperaturen, wobei die Trennfolie zwischen und in Kontakt mit laminatbildenden Schichten wie Press-Verbund-Platten, Netz-Platten, Kraft-Blättern und Deck-Blättern angeordnet ist, wobei diese Trennfolie in Kombination ein Blatt thermisch- und form-stabiles, glattes und hochzugfestes, beschichtbares Kunststoff-Polyester-, Nylon-, Zelluloseazetat-, Polyethersulfon-, Polyetherimid- oder Polyimid-Substrat aufweist, wobei wenigstens eine Oberfläche behandelt ist, um diese aufnahmefähig für ein acryliertes Oligomer-Flüssig-Harz-Überzugsmaterial zu machen, sowie eine dünne Schicht des Harz-Überzugsmaterials, das auf die behandelte Oberfläche aufgebracht und darauf ausgehärtet wird, wobei das Harz leicht von solch einer laminatbildenden Schicht lösbar ist.

7. Laminat-System nach Anspruch 6, bei dem das Harz im Elektronenstrahl härtbar und durch solche Bestrahlung gehärtet ist.

8. Laminat-System nach Anspruch 6, bei dem die Trennfolie flächenmäßig größer ist als das Laminat.

**Revendications**

1. Une structure de feuille de démoulage dans le moulage de stratifié sous moyenne à haute pression à température élevée dans laquelle ladite feuille de démoulage est intermédiaire à et en contact avec des couches constitutives de stratifié telles que des plaques pressées ensemble à la presse, des plaques de cales, des feuilles de kraft et des feuilles de protection, la structure de feuille de démoulage comprenant:

un film de polyester à surface traitée, de nylon ou d'acétate de cellulose comportant deux côtés, un tel traitement du film stimulant l'adhérence de la résine, et

une première couche mince de démoulage d'une résine de démoulage d'oligomère acrylaté polymérisé sur au moins un côté du film, ladite résine de démoulage étant facilement démoulable des dites couches constitutives de stratifié.

2. Une structure de feuille de démoulage telle que revendiqué à la revendication 1 dans lequel, en plus de la première couche mince, une deuxième couche mince de la même résine est prévue sur l'autre côté du film.

3. Une structure de feuille de démoulage telle que revendiquée à la revendication 1 dans laquelle la résine est une résine pouvant être polymérisée par un faisceau d'électrons.

4. Une structure de feuille de démoulage telle que revendiquée à la revendication 1 dans laquelle le film est un film de polyester comprenant du polyéthylènetérephthalate.

5. Une structure de feuille de démoulage telle que revendiquée à la revendication 1 dans laquelle le film de nylon comprend une résine de nylon de type 66 stabilisée thermiquement.

6. Un système de stratifié comprenant une structure de feuille de démoulage dans un moulage stratifié sous moyenne à haute pression à des températures élevées dans laquelle ladite feuille de démoulage est intermédiaire à et en contact avec des couches constitutives de stratifiés telles que des plaques pressées ensemble à la presse, des plaques de câles, des feuilles de kraft et des feuilles de protection, une telle feuille de démoulage comportant, en combinaison, une feuille de substrat plastique d'acétate de polyester, de nylon de cellulose, de polyéthersulfone, de polyétherimide ou polyimide apte à recevoir un revêtement, stable thermiquement et dimensionellement, uniforme et ayant une résistance à la traction élevée, une surface de laquelle au moins a été traitée pour rendre celle-ci réceptive à un matériau de revêtement de résine liquide d'oligomère acrylaté, une mince couche d'un tel matériau de revêtement de résine appliquée à la surface traitée et polymérisée sur celle-ci et à celle-ci, ladite résine étant facilement démoulable de telles couches constitutives de stratifié.

7. Système de stratifié tel que revendiqué à la revendication 6, dans lequel ladite résine est du type pouvant être polymérisé par émission de faisceau d'électrons et est polymérisé par une telle émission.

8. Un système de stratifié tel que revendiqué à la revendication 6, dans lequel la feuille de démoulage est d'une surface plus grande que les stratifiés.

EP 0 151 873 B1

FIG. I.

FIG. 2.

FIG. 2a.

## FIG. 3.

## FIG. 4.